# EUROPEAN PATENT APPLICATION

(11) **EP 2 540 800 A1**
(43) Date of publication of application: **02.01.2013**
(21) Application number: 11172183.3
(22) Date of filing: 30.06.2011
(51) Int. Cl.: C09K 13/00

(54) **Process for etching using sulfur compounds**

(71) Applicant: SOLVAY SA, 1120 Bruxelles (BE)
(72) Inventor: Riva, Marcello, 30175 Hannover (DE); Uenveren, Ercan, 30625 Hannover (DE)
(74) Representative: Mross, Stefan P.M.

(57) **Abstract**

Certain cyclic fluorosubstituted sulfolenes, [1,3,2]-dioxathiepines, sulfolanes and [1,3,2]-dioxathiepanes can be used as etching gases, especially for anisotropic etching in the production of etched items, for example, of semiconductors, e.g. semiconductor memories or semiconductor logic circuits, flat panels, or solar cells. Preferred compounds are hexafluoro-3-sulfolene, (*Z*)-perfluoro-4,7-dihydro-[1,3,2]-dioxathiepine, hexafluoro-3,4-dihydrosulfolane and 4,4,5,6,7,7-hexafluoro-[1,3,2]-dioxathiepane.

The compounds have the especial advantage that they allow the direct etching of photoresist-protected items where the pattern of the photoresist is defined by light of a wavelength of 193 nm, or even "extreme UV light". Nodes with a very narrow gap, e.g. nodes with any gap in the range of 130 nm to 7 nm and beyond, for example, nodes with gaps of 130 nm, 90 nm, 45 or 32 nm and even 17 nm and 7 nm, can be produced.

## Description

The invention concerns a process for etching using certain sulfur compounds. The process is useful for the preparation of etched items, e.g. semiconductors, solar cells, and flat panels.

During the manufacture of electronic devices, for example, semiconductor logics, optical and memory devices, for example, Dynamic Random Access Memories (DRAMs) or Central Processing Units (CPUs), logics or capacitors, often one or more steps of etching must be performed. Often, the material to be etched is silicon. Other materials to be etched are silicon oxide, silicon nitride, or low-k dielectrics, for example, FSG (fluorosilicate glass), or C-doped silicon dioxide. A preferred method of etching the items is performed using plasma in the presence of an etchant.

WO 97/24750 discloses the etching of silicon dioxide using unsaturated fluorocarbon gases of formula CₙF₂ₙ, especially C₂F₄ and C₃F₆.

It is observed that fluoropolymers formed are less stable over oxygen containing layers, e.g. silicon oxide layers, and thus enhance the selectivity of the etching method over barrier layers of other materials, e.g. Si₃N₄. It is stated that sharp side walls are formed when these gases are applied. It is assumed that the unsaturated gases form polymers on the surface of materials not to be etched (i.e. on the photoresist and the material beneath SiO₂).

US-A 6,508,948 discloses a method for etching features into a substrate by removing substrate material from selected areas. A patterned mask is provided and the item is placed in a plasma chamber. Halogenated heterocyclic hydrocarbons, for example, perfluoropyridine, are introduced into the chamber, and etching is started. Additional etching agents, e.g. CHF₃, C₃F₆ or C₄F₆ or carrier gases, e.g. nitrogen or argon, can be added. The process of anisotropic etching can be applied to perform micro fabrication of semi-conductor-based logic devices, memory devices and optoelectronic devices and micromechanical systems.

US-A 6,174,451 discloses oxide etching using hexafluorobutadiene, pentafluoropropylene and trifluoropropyne which are commercially available. WO 2010/007064 discloses the use of trifluorobutadiene and certain tetrafluorobutenes, especially 1,1,1,3-tetrafluorobutenes in the form of the € isomer, (Z) isomer and mixtures thereof, as etching gas, especially for anisotropic etching. WO 2010/115734 discloses the etching of the item is performed in the presence of at least one etching agent selected from the group consisting of aliphatic C2 to C10 hydrochlorofluoroalkene containing at least 1 chlorine atom and at least 1 fluorine atom.

Problem of the present invention is to provide useful etching agents, especially for use in anisotropic etching.

Consequently, the present invention provides for a process for producing an etched item including at least one step of anisotropically etching the item wherein the etching of the item is performed in the presence of at least one fluorinated sulfur compound selected from the group consisting of fluorinated cyclic sulfolenes of formula (I) 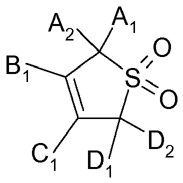 the respective isomer having formula (II), namely 4-A₁, 4-A₂, 5-B₁, 6-C₁, 7-D₁, 7-D₂-4,7-dihydro-[1,3,2]-dioxathiepine ;
fluorinated cyclic sulfolanes of formula (III) 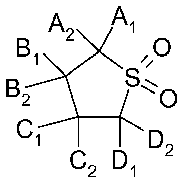 and the respective isomer having formula (IV), namely 4-A₁, 4-A₂, 5-B₁, 6-C₁, 7-D₁, 7-D₂-[1,3,2]-dioxathiepane ;
wherein A₁, A₂, B₁, B₂, C₁, C₂, D₁, D₂ are substituents selected from F and H with the proviso that at least one substituent of A₁, A₂, B₁, B₂, C₁, C₂, D₁, D₂ is F. Preferably, at least 4 of the substituents A₁, A₂, B₁, B₂, C₁, C₂, D₁, D₂ are F. Very preferably, in compounds of formula (I), (II), (III) and formula (IV), A₁, A₂, B₁, C₁, D₁ and D₂ are F, and the compound of formula (I) is hexafluoro-3-sulfolene, and the compound of formula (II) is (*Z*)-Perfluoro-4,7-dihydro-[1,3,2]-dioxathiepine ;
and additionally, in compounds of formula (III) and (IV), B₂ and C₂ are H, and the compound of formula (III) is hexafluoro-3,4-dihydrosulfolane, and the compound of formula (IV) is 4,4,5,6,7,7-hexafluoro-[1,3,2]-dioxathiepane.

Compounds of formula (I) can be prepared by the addition reaction of fluorosubstituted butadienes and SO₂. Preferably, polymerization inhibitors, for example, amines, e.g., phenyl-β-naphthylamine, or a pyrogallol, e.g. t-butyl pyrogallol, or alkenyl amines, e.g. diallylamine, are present. The process is described in US patents 3,514,469 ; 3,622,598 and 4,256,903 the content of which is incorporated by reference herein in their entirety.

The hydrogenation of the cyclic sulfolenes according to formula (I) to form sulfolanes acording to formula (III) can be performed as described in US patent 3,514,469 by reacting the sulfolenes with hydrogen in the presence of a hydrogenation catalyst, e.g. in the presence nickel, cobalt, copper, palladium, platin, or mixtures thereof, or in mixture with other metals, e.g. iron, zinc, chromium, nickel. If desired, the catalysts can be supported, e.g. on kieselguhr, aluminium oxide or diatomaceous earth.

The isomeric compounds having formula (II) can be prepared as described by N. B. Kazmina, 1. L. Knunyants, E. 1. Mysov and G. M. Kuzyants in Russian Chemical Bulletin (1978), Vol. 27, N° 1, pages 142 to 149 by the irradiation of a mixture comprising SO2 and hexafluorobutadiene with UV light; the authors applied irradiation with UV light from a mercury lamp having wavelengths in the range of 2483 to 5790 Angstrom. The most preferred compound, (*Z*)-perfluoro-4,7-dihydro-[1,3,2]-dioxathiepine (IIIa), 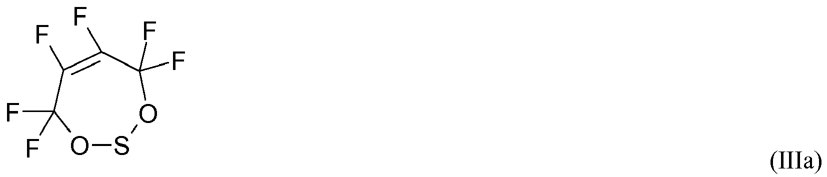 has a boiling point of about 85°C. It is stable for months in a sealed ampul. It is also denoted as 4,4,5,6,7,7-hexafluoro-1,3-dioxa-2-thia-5-cycloheptene.

The compounds of formula (IV) are available from the compounds of formula (III) by catalytic hydrogenation. Suitable catalysts are those mentioned above suitable to manufacture compounds of formula (III) from compounds of formula (I).

In the present invention, the terms "comprising" and "containing" include the meaning of "consisting of". Often in the description, it is expressly mentioned when the meaning "consisting of" is preferred.

According to one embodiment, the at least one compound of formula (I), (II), (III) or (IV) can be applied neat in plasma-assisted anisotropic etching. In such an etching process, often, they are vaporized under a vacuum, and introduced into a plasma-assisted etching chamber. The advantage of using nest compounds of formula (I) to (IV) is that the etching conditions are more easily defined for single etching compounds.

In a preferred embodiment, for etching, the at least one compound of formula (I), (II), (III) or (IV) is applied together with at least one additional compound which is gaseous at 20°C and 1 bar (abs.), or which has a boiling point at 1 bar (abs) of equal to or lower than 50°C. The at least one additional compound may be, for example, an inert compound, another etching agent which preferably etches anisotropically, or which improves the properties or conditions of the plasma ; some additional compounds may have several of these properties. A preferred diluent is, for example, N₂. Helium is an additive which mainly has diluent properties. Argon, neon and xenon are diluents, but often improve the properties of the plasma ; for example, the ignition or stability of the plasma is improved. Optionally, also hydrogen may be present to improve the formation of a protective film at the side walls of the trench to be etched.

It is also possible to apply the compound or compounds of formula (I), (II), (III) or (IV) together with other etching agents. Suitable co-etching gases are for example, the unsaturated fluorocarbon gases of formula CₙF₂ₙ, especially C₂F₄ and C₃F₆ disclosed in WO 97/24750, the fluoropyridine compounds of US-A 6,508,948, hydrofluorocarbons, for example, CHF₃ or CH₂F₂, hexafluorobutadiene, pentafluoropropylene and trifluoropropyne of US-A 6,174,451,or the trifluorobutadienes and tetrafluorobutenes of WO 2010/007064. The perfluorocarbon c-C₅F₈ may also be useful in this process. 1,1,3-triftuorobutadiene, 2,4,4,4-tetrafluoro-1-butene and (E) and (Z)-,1,1,3-tetraftuoro-2-butenes can be prepared as described in WO 2004/096737 by dehydrofluorination of 1,1,1,3,3-pentaftuorobutane thermally, for example, at a temperature in the range of 400 to 550°C, by means of a base, for example, an alkali metal hydroxide or a tertiary amine, or in the presence of a catalyst, for example, chromium on activated carbon. The compound of formula (I) to (IV), especially the sulfolene or sulfolane compound, may be mixed with the diluent, additive or co-etching agent before being introduced into the reactor, or inside the reactor by introducing the other compound separately into the reactor.

The compounds of formula (I), (II), (III) or (IV) are applied to etch an item in the plasma chamber. The term "an item" includes the singular and the plural, especially one item or a plurality of items, e.g. 2, 3, 4, 5 or more items. Whether only one item or a plurality of items are etched depends on the capacity of the used plasma chamber. If multiple items shall be etched simultaneously, a respective plasma chamber must be applied.

The compounds of formula (I) to (IV), preferably (*Z*)-perfluoro-4,7-dihydro-[1,3,2]-dioxathiepine, 4,4,5,6,7,7-hexafluoro-[1,3,2]-dioxathiepane, and especially hexafluoro-3,4-dihydrosulfolane and hexafluoro-3-sulfolene, can be applied for those purposes in etching processes for which fluorinated carbons are generally used. They can be applied as single compounds. The term "single" denotes that the etchant gas contains a single compound, for example, a single fluorosubstituted cyclic sulfolene or sulfolane, but no further carbon containing etchant or other fluorosubstituted etchants. The term "single" does not exclude the presence of additive gases or diluent gases, such as nitrogen, helium, xenon, or argon.

The compounds of formula (I) to (IV), preferably the cyclic fluorinated sulfolenes and sulfolanes, may be used in etching processes, preferably for the manufacture of semiconductor memories and logics, like e.g., DRAMs and CPUs.

The compounds of formula (I) to (IV), preferably the fluorinated sulfolenes and sulfolanes, especially hexafluoro-3-sulfolene and hexafluoro-3,4-dihydrosulfolane, are preferably applied to etch dielectric materials, for example, silicon dioxide, silicon nitride, low and ultra low-k dielectrics like FSG, carbon doped dielectrics and similar material.

The compounds of formula (I) to (IV) are especially suitable in processes including one or more steps of anisotropic etching (optionally diluted with helium, argon, xenon or other additive or diluent gases). Argon and xenon are additive gases which dilute the fluorinated sulfolene and sulfolane compound or compounds, but which also can influence the selectivity of the etching process.

The conditions during etching correspond to those usually applied. For example, direct plasma or indirect plasma can be applied. Often, the pressure in the plasma chamber is equal to or below 150 Pa. Preferably, the pressure is from 1 to 120 Pa.

The compounds of formula (I) to (IV), preferably the fluorinated sulfolene and sulfolane compounds, are especially suitable in the field of technique as described in US-A 6,174,451 and especially in WO 2000/30168 being directed to the production of silicon integrated circuits.

The technique described in WO 2000/30168 is explained here in detail in view of the application of the sulfolene and sulfolaner compounds. It concerns generally the etching of silicon integrated circuits, and especially the etching of dielectrics, for example, silicon oxide and related materials in a process that is capable of greatly reduced etching rates for silicon nitride and other non-oxide materials but still producing a vertical profile in the oxide. Oxide etching, a somewhat generic term used for silica, SiO₂, and slightly non-stoichiometric compositions SiOₓ, and for closely related materials, for example, oxide glasses, e.g. borophosphosilicate glass, and even silicon oxynitride, presents some difficult challenges. Oxide materials, optionally doped by e.g. fluorine (fluorosilicate glass, "FSG") or carbon (e.g. Black Diamond^{®} of Applied Materials), so-called "low-k dielectrics", and "ultra low-k dielectrics", are principally used for electrically insulating layers. In such processes, the sulfolenes ans sulfolanes can be applied as etchant.

Most often, the circuit comprises a silicon base with a polysilicon gate later attached thereto. A silicon nitride layer serves as electrical insulator. The silicon nitride layer and the polysilicon gate layer are in turn covered by an oxide layer, and a photoresist layer is deposited over the oxide layer. The photoresist layer is photographically defined into a mask. A subsequent etching step etches a contact hole through the oxide layer and stops on the silicon nitride layer.

While the thickness of the oxide layer cannot be reduced much below 500 to 1,000 nanometers (nm), the minimum feature sizes of contact via holes penetrating the oxide layer are continuously decreasing. The node, i.e. the distance between the walls of the etched items (e.g. contacts and holes), is permanently minimized. The compounds of formula (I) to (IV) are especially suitable for anisotropic etching of nodes with very narrow gaps, especially in the range of 130 nm to 7 nm, especially the 130 nm node, 90 nm node, 45 nm node, 32 nm node, 22 nm node and 17 nm node, and even the 7 nm node in the future ; the compounds can, of course, be applied to produce nodes with any gaps between 130 nm and 7 nm, and even beyond this range.

Light with a wavelength of 248 nm or 193 nm was applied for 130 nm nodes. For nodes with a wall distance of 90 nm and below, light with a wavelength of 193 nm is applied, and light with a wavelength of 157 nm to produce 65 nm nodes. The minimum feature size of contact and via holes is or will be shrinking to 45 nm, 32 nm and even only 22 nm. The immersion lithography technique allows to achieve definitions which can extend the use of this light source to the 32 nm node. "Extreme UV light" will supposedly be applied for the 22 nm node in the future. Some information about EUV light, e.g. EUV light with a wavelength of 13.5 nm, can be found in US patent 7372059. Another technique which can be used to extend the application of the 193 nm light is the so called the "double patterning method". It allows for the application of light of rather long wavelength, e.g. 193 nm, to produce very narrow nodes, e.g. even those with 90 nm nodes and gaps lower than 90 nm. A first photoresist is formed and developed, and then, a second photoresist is developed. This method is for example described in WO 008/036496. It has to be noted that the nodes given above are only examples for nodes which can be produced. The compounds of formula (I) to (IV) are used in gaseous or vapor form, and they are very suitable as etching agents in the manufacture of memory or a logic circuit, for example, a DRAM or CPU. The compounds of the present invention have good polymer-forming properties and can be easily produced from commercially available compounds.

Photoresists used in processes applying such light sources turned out to be rather "soft", having not enough physical resistance under the conditions used in etching. Consequently, the edges of the photoresist were attacked by the etchant, with the result that the desired gap could not be achieved but formed a tapered gap. Several proposals to overcome this disadvantage are described by E.S. Moyer, J. Bremmer, C. Brick, P.F. Fu, A. Shirahata, S. Wang and C. Yeakle in Semiconductor International, published Saturday, September 1, 2007. A technically feasible example is the "hard mask" method which provides a hard mask e.g. from carbon between the photoresist layer and the item to be etched. The hard mask allows for etching without a broadening of the etched hole or contact.

The disadvantage of such processes is that an additional step is needed : either applying a second photoresist pattern, or applying the hard mask.

The current invention provides another approach to solve the problem associated with the softness of the photoresist by applying a compound of formula (I) to (IV), preferably a fluorinated sulfolene and/or sulfolane, as etchant. These compounds are considered as "soft" etchants especially suitable for the "soft" photoresists. Often, the compounds are applied together with argon, xenon, nitrogen and/or helium, optionally in the presence of hydrogen. If desired, they can be applied together with fluorinated compounds applicable as etchant, e.g. saturated perfluoroalkanes or saturated hydrofluoroalkanes, unsaturated perfluoroalkenes or perfluoroalkadienes or other unsaturated hydrofluoroalkenes or hydrofluoroalkadienes. For example, a polymerizing gas may be added, e.g. difluoromethane ; but the compounds of the present invention have good polymerizing properties by themselves.

The etch process can be performed in a high-density plasma, such as an inductively coupled reactor, or a low-density plasma, such as a capacitively coupled reactor which is preferred. Often, the pressure is kept below about 20 millitorr.

Preferably, the compound of formula (I), (II), (III) or (IV), preferably (*Z*)-perfluoro-4,7-dihydro-[1,3,2]-dioxathiepine, 4,4,5,6,7,7-hexaftuoro-[1,3,2]-dioxathiepane, and especially hexafluoro-3,4-dihydrosulfolane and hexafluoro-3-sulfolene (or a mixture containing the compound) is introduced into the plasma reactor and applied together with argon ; according to one alternative, it is introduced diluted with argon, according to another alternative, argon is introduced separately into the reactor. If desired, the etching step could be divided into two sub steps wherein the compound of formula (I) to (IV), especially the fluorinated sulfolene or sulfolane compound, is present, the first step being tuned for vertical profile ; the second step is tuned for nitride selectivity and no etch stop. Often, a one step approach of etching and sidewall protection is preferred.

Mixtures of xenon (Xe) and argon (Ar) may be applied to tune the relative selectivity of the etchant chemistry between the dielectrics and the barrier layer, enhancing the selectivity.

The advantage of the cyclic fluorosubstituted compounds of the present invention is the high selectivity, easy activation ; "gentle" plasma is formed when [1,3,2]-dioxathiepanes or sulfolanes are applied which are substituted by fluorine and hydrogen, e.g. 4,4,5,6,7,7-hexafluoro-[1,3,2]-dioxathiepane or hexafluoro-3,4-dihydrosulfolane, due to the H content : H radicals formed in the plasma function as F radical scavengers. Sulfolenes, having multiple bonds, also form a gentle plasma. Thus, it is possible to avoid the additional step of applying a hard mask or double patterning. If desired, the sulfolene and sulfolane compounds nevertheless can be applied in such hard mask or double patterning processes.

Another aspect of the present invention concerns a composition of matter in the form of mixtures comprising or, preferably, consisting of at least one cyclic fluorosubstituted sulfolene compound of formula (I) 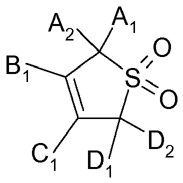 the respective isomer having formula (II), namely 4-A₁, 4-A₂, 5-B₁, 6-C₁, 7-D₁, 7-D₂-4,7-dihydro-[1,3,2]-dioxathiepine ;
cyclic fluorosubstituted sulfolane compound of formula (III) 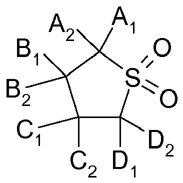 and the respective isomer having formula (IV), namely 4-A₁, 4-A₂, 5-B₁, 6-C₁, 7-D₁, 7-D₂-[1,3,2]-dioxathiepane ;
wherein A₁, A₂, B₁, B₂, C₁, C₂, D₁, D₂ are substituents selected from F and H with the proviso that at least one substituent of A₁, A₂, B₁, B₂, C₁, C₂, D₁, D₂ is F. Preferably, at least 4 of the substituents A₁, A₂, B₁, B₂, C₁, C₂, D₁, D₂ are F ; and of at least one gas selected from the group consisting of nitrogen, helium, xenon, argon, and any combinations of two or more thereof.

Optionally, additive gases, for example one or more hydrogen sources, e.g. hydrocarbons, preferably elemental hydrogen (which serves as fluorine trap in etching), or other passivating gases may be present. A "passivating gas" is a gas which forms a protective polymer layer ; an example is CH₂F₂. In the following, these compositions of matter are often denoted as "mixtures".

Mixtures containing or, preferably, consisting, of xenon or argon, and at least one cyclic fluorosubstituted sulfolene of formula (I), [1,3,2]-dioxathiepine of formula (II), sulfolane of formula (III) or [1,3,2]-dioxathiepane of formula (IV) are especially preferred. Most preferred are mixtures containing or, especially, consisting of at least one cyclic fluorosubstituted sulfolene of formula (I),

[1,3,2]-dioxathiepine of formula (II), sulfolane of formula (III) or [1,3,2]-dioxathiepane of formula (IV) and argon.

Preferably, the compound of formula (I) is hexafluoro-3-sulfolene ; the compound of formula (II) is (*Z*)-perfluoro-4,7-dihydro-[1,3,2]-dioxathiepine ; the compound of formula (III) is hexafluoro-3,4-dihydrosulfolane ; and the compound of formula (IV) is 4,4,5,6,7,7-hexafluoro-[1,3,2]-dioxathiepane.

More preferably, the fluorosubstituted compound is (*Z*)-perfluoro-4,7-dihydro-[1,3,2]-dioxathiepine or hexafluoro-3,4-dihydrosulfolane.

One especially preferred embodiment concerns mixtures consisting of hexafluoro-3-sulfolene and at least one gas selected from the group consisting of helium, xenon, argon, and any combinations of two or more thereof, and optionally at least one hydrogen source, preferably hydrogen.

In this embodiment, xenon, argon and mixtures thereof are preferred gases. Argon is especially preferred.

Another especially preferred embodiment concerns mixtures consisting of hexafluoro-3,4-dihydrosulfolane and at least one gas selected from the group consisting of helium, xenon, argon, and any combinations of two or more thereof, and optionally at least one hydrogen source, preferably hydrogen.

Another especially preferred embodiment concerns mixtures consisting of (*Z*)-perfluoro-4,7-dihydro-[1,3,2]-dioxathiepine and at least one gas selected from the group consisting of helium, xenon, argon, and any combinations of two or more thereof, and optionally at least one hydrogen source, preferably hydrogen.

Another especially preferred embodiment concerns mixtures consisting of 4,4,5,6,7,7-hexafluoro-[1,3,2]-dioxathiepane and at least one gas selected from the group consisting of helium, xenon, argon, and any combinations of two or more thereof, and optionally at least one hydrogen source, preferably hydrogen.

In these embodiments, xenon, argon and mixtures thereof are preferred gases. Argon is especially preferred.

The composition of matter in the form of mixtures is very suitable as etching gas with passivating capability as described in detail above. The composition of matter in condensed form is preferred, e.g. being pressurized or kept at low temperature. The composition of matter according to the invention is very preferably liquid, but may be partially present in the form a gas phase, depending on the vapor pressure.

The content of the fluorosubstituted compound of formula (I), formula (II), formula (III) or formula (IV) in the compositions of matter is equal to or greater than 10 % by volume. Preferably, it is equal to or lower than 80 % by volume. Preferably, at least one gas selected from the group consisting of helium, xenon, and argon are the balance to 100 % by volume. The compositions can be free of hydrogen. If hydrogen is present, it is preferably comprised in a range from 2 to 10 % by volume. The percentages refer to the total weight of the compositions.

If vaporized, the volume ratio in mixtures comprising or consisting of xenon and/or argon and the at least one fluorosubstituted compound of formula (I), formula (II), formula (III) or formula (IV), preferably selected from the group consisting of hexafluoro-3-sulfolene, (*Z*)-perfluoro-4,7-dihydro-[1,3,2]-dioxathiepine, hexafluoro-3,4-dihydrosulfolane and 4,4,5,6,7,7-hexafluoro-[1,3,2]-dioxathiepane, i.e. the volume ratio of the total content of all noble gases contained, and the total amount of all fluorosubstituted compounds of formula (I) to (IV), is preferably equal to or greater than 1:3, more preferably equal to or greater than 1:2. It is preferably equal to or lower than 3:1 and more preferably equal to or greater than 2:1 by volume.

Gas mixtures comprising or consisting of hexafluoro-3,4-dihydrosulfolane and hexafluoro-3-sulfolene and argon or argon and xenon are especially preferred.

If the compounds of formula (I) to (IV) are applied together with gases such as nitrogen, helium, xenon, argon, and any combinations of two or more thereof, or one or more hydrogen sources, e.g. hydrocarbons or, preferably, elemental hydrogen, each compound may be introduced separately into the reactor. Alternatively, they can be premixed, e.g. by introducing the components into a common line connected to the reactor. In another alternative, the components are stored as a mixture in a storage tank, i.e. they are present in mixed form therein and can be drawn off and introduced into the reactor in perfectly mixed form.

Should the disclosure of any patents, patent applications, and publications which are incorporated herein by reference conflict with the description of the present application to the extent that it may render a term unclear, the present description shall take precedence.

The following examples are intended to explain the invention in further detail without the intention to limit it.

### EXAMPLE 1 : Compositions of matter especially suitable for anisotropic etching

The compositions are prepared by filling the respective compound of formula (I) or (III), argon and optionally nitrogen and hydrogen, respectively, in a pressure-resistant storage tank. The order of introducing the constituents is not critical, but it is preferred to add the gaseous compounds after the compounds which are liquid at ambient conditions.

Hexafluoro-3-sulfolene can be prepared as described above from hexafluorobutadiene and SO₂ ; hydrogenation of hexafluoro-3-sulfolene provides hexafluoro-3,4-dihydrosulfolane.

**Table 1 : Etching compositions comprising hexafluoro-3-sulfolene (amounts given in % by volume)**

| Example | C₆F₆SO₂* | Ar | Xe or N₂ | H₂ |
|---|---|---|---|---|
| 1.1 | 15 | 85 | -- | -- |
| 1.2 | 20 | 80 | -- | -- |
| 1.3 | 30 | 70 | -- | -- |
| 1.4 | 15 | 75 | -- | 10 |
| 1.5 | 20 | 70 | -- | 10 |
| 1.6 | 20 | 75 | Xe:5 | -- |
| 1.7 | 20 | 75 | Xe:0 N₂:5 | |
| 1.8 | 20 | 80 | -- | -- |
| 1.9 | 30 | 70 | -- | -- |
| 1.10 | 40 | 60 | | |
| 1.11 | 45 | 55 | -- | -- |
| 1.12 | 50 | 50 | -- | -- |
| 1.13 | 55 | 45 | | |
| 1..14 | 60 | 40 | | |

| | | | | |
|---|---|---|---|---|
| * Hexafluoro-3-sulfolene | | | | |

**Table 2 : Etching compositions comprising hexafluoro-3,4-dihydro-sulfolane (amounts given in % by volume)**

| Example | C₆F₆H₂ SO₂* | Ar | Xe or N₂ | H₂ |
|---|---|---|---|---|
| 1.15 | 10 | 90 | -- | -- |
| 1.16 | 15 | 85 | -- | -- |
| 1.17 | 20 | 80 | -- | -- |
| 1.18 | 20 | 75 | -- | 5 |
| 1.19 | 20 | 70 | Xe:10 | -- |
| 1.20 | 30 | 70 | -- | -- |
| 1.21 | 40 | 60 | -- | -- |
| 1.22 | 45 | 55 | -- | -- |
| 1.23 | 50 | 50 | -- | 5 |
| 1.24 | 55 | 45 | -- | -- |
| 1.25 | 60 | 40 | -- | -- |
| 1.26 | 20 | 70 | Xe:0 N₂:10 | |

| | | | | |
|---|---|---|---|---|
| * hexafluoro-3,4-dihydrosulfolane | | | | |

The compositions mentioned above are prepared by filling the sulfur compound into a pressure resistant storage tank and adding the gaseous other compound(s) under pressure.

### EXAMPLE 2 : Manufacture of a semiconductor

### 2.1. Separate feeding of hexafluoro-3,4-dihydrosulfolane and argon

Etching can be performed in an Inductive Coupled Plasma Source (ICP) etch reactor or in a Capacitively Coupled Plasma Source (CCP) reactor which is available from Applied Materials. A self-aligned contact (SAC) is formed as described in FIG. 1 and page 3 of WO 2000/302168. A polysilicon gate layer, a tungsten silicide barrier and glue layer, and a silicon nitride cap layer are deposited and photolithographically formed into two closely related spaced gate structures having a gap there between. Then, a silicon nitride layer is deposited via CVD on the structure, and dopant ions are implanted. A dielectric Si0₂ layer is deposited over the structure, a photoresist layer is deposited over the over the oxide layer and photographically defined using light with a wavelength of 193 nm into a mask. Then, using hexafluoro-3,4-dihydrosulfolane and argon, delivered separately from each other in a weight ratio of 1:4 into the plasma reactor, the SiO₂ layer is etched. A contact hole with a diameter of less than 50 nm is achieved with an aspect ratio of > 20.

### 2.2. Feeding of hexafluoro-3,4-dihydrosulfolane and argon in the form of a mixture

Example 2.1. is repeated, but hexafluoro-3,4-dihydrosulfolane and argon are fed into the plasma reactor premixed in the form of a gas/vapor mixture. If desired, the mixture can be taken from a storage tank comprising a liquefied composition of matter consisting of hexafluoro-3,4-dihydrosulfolane and argon.

### EXAMPLE 3 : Etching of low-k dielectric layers

### Example 3.1 : Etching of low-k dielectric layers

Example 2 is repeated but the items to be etched are low-k dielectric layers instead of SiO₂ layers.

### Example 3.2 : Etching of ultra-low-k dielectric layers

Example 2 is repeated but the items to be etched are low-k dielectric layers instead of SiO₂ layers.

### EXAMPLE 4 : Manufacture of a semiconductor using hexafluoro-3,4-dihydrosulfolane

Example 2 is repeated using a vaporized mixture containing 20 % by volume of hexafluoro-3,4-dihydrosulfolane, 70 vol- % of argon, and 10 vol- % xenon. The mixture is taken from a storage tank containing this mixture in liquid form.

### EXAMPLE 5 : Manufacture of a semiconductor using hexafluoro-3-sulfolene

Example 2 is repeated using a vaporized mixture containing 20 % by volume of hexafluoro-3-sulfolene, 70 vol- % of argon, and 10 vol- % xenon. The mixture is taken from a storage tank containing this mixture in liquid form. *EXAMPLE 6 :* Manufacture of a semiconductor using hexafluoro-3-sulfolene

Example 2 is repeated using a vaporized mixture containing 50 % by volume of hexafluoro-3-sulfolene and 50 % by volume of argon. The mixture is taken from a storage tank containing this mixture in liquid form. *EXAMPLE 7 :* Manufacture of a semiconductor using hexafluoro-3,4-dihydrosulfolane

Example 2 is repeated using a vaporized mixture containing 50 % by volume of hexafluoro-3,4-dihydro-sulfolane and 50 vol- % of argon, and 10 vol- %.. The mixture is taken from a storage tank containing this mixture in liquid form.

### EXAMPLE 8 : Compositions of matter especially suitable for anisotropic etching

The compositions are prepared by filling the respective compound of formula (II) or (IV), argon and optionally nitrogen and hydrogen, respectively, in a pressure-resistant storage tank. The order of introducing the constituents is not critical, but it is preferred to add the gaseous compounds after the compounds which are liquid at ambient conditions.

(*Z*)-perfluoro-4,7-dihydro-[1,3,2]-dioxathiepine can be prepared as described above from hexafluorobutadiene and SO₂ by irradiation of a respective mixture in a reactor made from quartz glass with UV light from a mercury lamp in a quartz housing ; hydrogenation of (*Z*)-perfluoro-4,7-dihydro-[1,3,2]-dioxathiepine provides 4,4,5,6,7,7-hexafluoro-[1,3,2]-dioxathiepane.

**Table 3 : Etching compositions comprising (Z)-perfluoro-4,7-dihydro-[1,3,2]-dioxathiepine (amounts given in % by volume)**

| Example | C₆F₆SO₂* | Ar | Xe or N₂ | H₂ |
|---|---|---|---|---|
| 8.1 | 15 | 85 | -- | -- |
| 8.2 | 20 | 80 | -- | -- |
| 8.3 | 30 | 70 | -- | -- |
| 8.4 | 15 | 75 | -- | 10 |
| 8.5 | 20 | 70 | -- | 10 |
| 8.6 | 20 | 75 | Xe:5 | -- |
| 8.7 | 20 | 75 | Xe:0 N₂:5 | |
| 8.8 | 20 | 80 | -- | -- |
| 8.9 | 30 | 70 | -- | -- |
| 8.10 | 40 | 60 | | |
| 8.11 | 45 | 55 | -- | -- |
| 8.12 | 50 | 50 | -- | -- |
| 8.13 | 55 | 45 | | |
| 8.14 | 60 | 40 | | |

| | | | | |
|---|---|---|---|---|
| * (Z)-perfluoro-4,7-dihydro-[1,3,2]-dioxathiepine | | | | |

**Table 4 : Etching compositions comprising 4,4,5,6,7,7-hexafluoro-[1,3,2]-dioxathiepane (amounts given in % by volume)**

| Example | C₆F₆H₂SO₂* | Ar | Xe or N₂ | H₂ |
|---|---|---|---|---|
| 8.15 | 10 | 90 | -- | -- |
| 8.16 | 15 | 85 | -- | -- |
| 8.17 | 20 | 80 | -- | -- |
| 8.18 | 20 | 75 | -- | 5 |
| 8.19 | 20 | 70 | Xe:10 | -- |
| 8.20 | 30 | 70 | -- | -- |
| 8.21 | 40 | 60 | -- | -- |
| 8.22 | 45 | 55 | -- | -- |
| 8.23 | 50 | 50 | -- | 5 |
| 8.24 | 55 | 45 | -- | -- |
| 8.25 | 60 | 40 | -- | -- |
| 8.26 | 20 | 70 | Xe:0 N₂:10 | |

| | | | | |
|---|---|---|---|---|
| * 4,4,5,6,7,7-hexafluoro-[1,3,2]-dioxathiepane | | | | |

The compositions mentioned above are prepared by filling the sulfur compound into a pressure resistant storage tank and adding the gaseous other compound(s) under pressure.

### EXAMPLE 9 : Manufacture of a semiconductor

Example 9.1. Separate feeding of (*Z*)-perfluoro-4,7-dihydro-[1,3,2]-dioxathiepine and argon

Etching can be performed in an Inductive Coupled Plasma Source (ICP) etch reactor or in a Capacitively Coupled Plasma Source (CCP) reactor which is available from Applied Materials. A self-aligned contact (SAC) is formed as described in FIG. 1 and page 3 of WO 2000/302168. A polysilicon gate layer, a tungsten silicide barrier and glue layer, and a silicon nitride cap layer are deposited and photolithographically formed into two closely related spaced gate structures having a gap there between. Then, a silicon nitride layer is deposited via CVD on the structure, and dopant ions are implanted. A dielectric SiO₂ layer is deposited over the structure, a photoresist layer is deposited over the over the oxide layer and photographically defined using light with a wavelength of 193 nm into a mask. Then, using (*Z*)-perfluoro-4,7-dihydro-[1,3,2]-dioxathiepine and argon, delivered separately from each other in a weight ratio of 1:4 into the plasma reactor, the SiO₂ layer is etched. A contact hole with a diameter of less than 50 nm is achieved with an aspect ratio of > 20.

Example 9.2. Feeding of (*Z*)-perfluoro-4,7-dihydro-[1,3,2]-dioxathiepine and argon in the form of a mixture

Example 9.1. is repeated, but (*Z*)-perfluoro-4,7-dihydro-[1,3,2]-dioxathiepine and argon are fed into the plasma reactor premixed in the form of a gas/vapor mixture. If desired, the mixture can be taken from a storage tank comprising a liquefied composition of matter consisting of (*Z*)-perfluoro-4,7-dihydro-[1,3,2]-dioxathiepine and argon.

## Claims

1. A process for producing an etched item including at least one step of anisotropically etching the item wherein the etching of the item is performed in the presence of at least one fluorinated sulfur compound selected from the group consisting of fluorinated cyclic sulfolenes of formula (I) 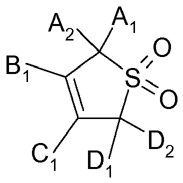 the respective isomer having formula (II), namely 4-A₁, 4-A₂, 5-B₁, 6-C₁, 7-D₁, 7-D₂-4,7-dihydro-[1,3,2]-dioxathiepine ;
fluorinated cyclic sulfolanes of formula (III) 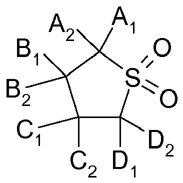 and the respective isomer having formula (IV), namely 4-A₁, 4-A₂, 5-B₁, 6-C₁, 7-D₁, 7-D₂-[1,3,2]-dioxathiepane ;
wherein A₁, A₂, B₁, B₂, C₁, C₂, D₁, D₂ are substituents selected from F and H with the proviso that at least one substituent of A₁, A₂, B₁, B₂, C₁, C₂, D₁, D₂ is F.

2. The process of claim 1 wherein at least 4 of the substituents A₁, A₂, B₁, B₂, C₁, C₂, D₁, D₂ are F.

3. The process of claim 1 or 2 wherein the compound of formula (I) is hexafluoro-3-sulfolene ; the compound of formula (II) is (*Z*)-perfluoro-4,7-dihydro-[1,3,2]-dioxathiepine ; the compound of formula (III) is hexafluoro-3,4-dihydrosulfolane, and the compound of formula (IV) is 4,4,5,6,7,7-hexafluoro-[1,3,2]-dioxathiepane.

4. The process of anyone of claims 1 to 3 wherein the item is a semiconductor memory or a semiconductor logic circuit.

5. The process of anyone of claims 1 to 4 wherein a photoresist is applied for the photolithographical definition of a pattern wherein the photoresist is selected among photoresists definable by light with a wavelength of less than 248 nm, 193 nm or in the "extreme UV light" region.

6. The process of claim 5 for etching a gap of a contact or hole wherein the gap of the contact or hole is in the range from 130 nm to 7 nm, and is preferably 130 nm, 90 nm, 45 nm, 32 nm, 22 nm, 17 nm or 7 nm.

7. The process of anyone of claims 1 to 6 wherein the compound of formula (I), formula (II), formula (III) or formula (IV) is applied together with a gas selected from the group consisting of nitrogen, xenon, helium, argon, and any combinations of two or more thereof.

8. The process according to claim 7 wherein the compound of formula (I) or formula (III) or (IV), preferably of formula (III), is applied together with xenon and argon.

9. A composition of matter comprising or consisting of at least one compound selected from the group consisting of fluorinated cyclic sulfolene of formula (I) 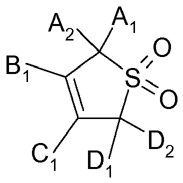 the respective isomer having formula (II), namely 4-A₁, 4-A₂, 5-B₁, 6-C₁, 7-D₁, 7-D₂-4,7-dihydro-[1,3,2]-dioxathiepine ;
fluorinated cyclic sulfolanes of formula (III) 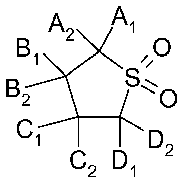 and the respective isomer having formula (IV), namely 4-A₁, 4-A₂, 5-B₁, 6-C₁, 7-D₁, 7-D₂-[1,3,2]-dioxathiepane ;
wherein A₁, A₂, B₁, B₂, C₁, C₂, D₁, D₂ are substituents selected from F and H with the proviso that at least one substituent of A₁, A₂, B₁, B₂, C₁, C₂, D₁, D₂ is F,
and a gas selected from the group consisting of nitrogen, xenon, helium, argon, and any combinations of two or more thereof.

10. The composition of matter of claim 9 wherein the compound of formula (I) is hexafluoro-3-sulfolene ; the compound of formula (II) is (Z)-perfluoro-4,7-dihydro-[1,3,2]-dioxathiepine ; the compound of formula (III) is hexafluoro-3,4-dihydrosulfolane ; and the compound of formula (IV) is 4,4,5,6,7,7-hexafluoro-[1,3,2]-dioxathiepane.

11. The composition of matter of anyone of claims 9 or 10 consisting of at least one compound selected from the group consisting of hexafluoro-3-sulfolene ; (*Z*)-perfluoro-4,7-dihydro-[1,3,2]-dioxathiepine ; hexafluoro-3,4-dihydrosulfolane or 4,4,5,6,7,7-hexafluoro-[1,3,2]-dioxathiepane ; and at least one gas selected from the group consisting of xenon, argon, nitrogen.

12. The composition of matter of anyone of claims 9 to 11 wherein the volume ratio between argon and the compound of formula (I), (II), (III) or (IV) and any combinations of two or more thereof is equal to or greater than 1:3, preferably equal to or greater than 1:2, and equal to or lower than 3:1 and preferably equal to or lower than 2:1.

13. The composition of matter of anyone of claims 9 to 12 wherein the compound is (*Z*)-perfluoro-4,7-dihydro-[1,3,2]-dioxathiepine or hexafluoro-3,4-dihydrosulfolane.

14. The composition of matter of anyone of claims 9 to 13 comprising xenon.
